# EUROPÄISCHE PATENTSCHRIFT

(11) **EP 2 322 695 B1**
(45) Veröffentlichungstag und Bekanntmachung des Hinweises auf die Patenterteilung: **23.11.2011**
(21) Anmeldenummer: 10188864.2
(22) Anmeldetag: 26.10.2010
(51) Int. Cl.: C30B 13/00, C30B 13/20, C30B 13/26

(54) **Verfahren zur Herstellung eines Einkristalls aus Silizium durch Umschmelzen von Granulat**
Method for producing a single crystal of silicon by remelting granules
Procédé de fabrication d'un monocristal en silicium par refonte de granulés

(30) Priorität: 11.11.2009 DE 102009052745
(43) Veröffentlichungstag der Anmeldung: 18.05.2011
(73) Patentinhaber: Siltronic AG, 81737 München (DE)
(72) Erfinder: von Ammon, Wilfried, 5122, Hochburg (AT); Altmannshofer, Ludwig, 84323, Massing (DE); Wasner, Martin, 5122, Hochburg (AT)
(74) Vertreter: Staudacher, Wolfgang

(56) Entgegenhaltungen:
- DE-A1- 10 204 178
- DE-A1-102008 013 326

## Beschreibung

Gegenstand der Erfindung ist ein Verfahren zur Herstellung eines Einkristalls aus Silizium durch Umschmelzen von Granulat mit Hilfe einer Vorrichtung, die eine sich drehende Platte aus Silizium mit einer zentralen Öffnung umfasst und ein, die Öffnung umschließendes und sich unter die Platte aus Silizium erstreckendes, konisches Rohr aus Silizium, des Weiteren eine erste, über der Platte aus Silizium angeordnete Induktionsheizspule zum Schmelzen von Silizium und schließlich eine zweite, unter der Platte aus Silizium angeordnete Induktionsheizspule zum Kristallisieren von geschmolzenem Silizium.

Das Verfahren ähnelt dem Zonenziehen, das auch FZ-Verfahren ("floating zone method") genannt wird. Der besondere Unterschied besteht darin, dass an Stelle eines polykristallinen Vorratsstabes ("feed rod") aus Silizium polykristallines Granulat aus Silizium umgeschmolzen wird. Das Granulat kann durch Abscheiden in der Wirbelschicht erhalten werden. Zum Schmelzen des Granulats und zum Kristallisieren des geschmolzenen Granulats werden jeweils eigene Induktionsheizspulen ("inductor coils") eingesetzt, die sich über, beziehungsweise unter einer sich drehenden Platte aus Silizium befinden. Das Granulat aus Silizium wird mit Hilfe der ersten Induktionsheizspule geschmolzen und fließt als Film aus flüssigem Silizium durch die zentrale Öffnung und das konische Rohr der Platte und bildet eine Schmelze, die, von der zweiten Induktionsheizspule gesteuert, zu einem wachsenden Einkristall aus Silizium kristallisiert wird.

In der DE 102 04 178 A1 sind das Verfahren und Vorrichtungen näher beschrieben, die zur Durchführung des Verfahrens geeignet sind.

Die DE 10 2008 013 326 A1 umfasst die Beschreibung einer Induktionsheizspule zum Schmelzen von Granulat, die im Zentrum der unteren Seite hervorstehende Segmente aufweist, mit deren Hilfe der, von der Platte und durch das konische Rohr zur Schmelze fließende Film aus flüssigem Silizium erhitzt und flüssig gehalten werden kann.

Es hat sich jedoch gezeigt, dass auch bei Verwendung einer derartigen Spule nicht zuverlässig verhindert werden kann, dass das Rohrende des konischen Rohrs im Verlauf des Wachstums eines konusförmig erweiterten Abschnitts des Einkristalls immer enger wird und schließlich durch, in festen Zustand übergehendes Silizium zufriert.

Aufgabe der vorliegenden Erfindung ist es, Maßnahmen zu ergreifen, die ein derartiges Zufrieren des Rohrendes des konischen Rohrs zuverlässig verhindern.

Gelöst wird die Aufgabe durch ein Verfahren zur Herstellung eines Einkristalls aus Silizium durch Umschmelzen von Granulat, umfassend das Kristallisieren eines konusförmig erweiterten Abschnitts (1) des Einkristalls mit Hilfe einer Induktionsheizspule (8), die unter einer sich drehenden Platte 5 aus Silizium angeordnet ist; und das Zuführen von induktiv geschmolzenem Silizium durch ein konisches Rohr (6) der Platte (5), das eine zentrale Öffnung der Platte (5) umschließt und sich unter die Platte erstreckt, zu einer Schmelze (3), die sich auf dem konusförmig erweiterten Abschnitt (1) des Einkristalls befindet und die Kontakt zu einem Rohrende des konischen Rohrs (6) hat, dadurch gekennzeichnet, dass mit Hilfe der unter der Platte (5) angeordneten Induktionsheizspule (8) ausreichend Energie bereitgestellt wird, damit der Außendurchmesser D des Rohrendes nicht kleiner als 15 mm ist, solange der konusförmig erweiterte Abschnitt (1) des Einkristalls einen Durchmesser von 15 bis 30 mm aufweist und kristallisiert wird.

Am Anfang des Verfahrens wird das konische Rohr, das zu diesem Zeitpunkt am Rohrende noch durch eine Schicht aus festem Silizium verschlossen ist, mit Hilfe der, unter der Platte angeordneten Induktionsheizspule am Rohrende angeschmolzen, wobei ein kleines Volumen an flüssigem Silizium entsteht. Das Rohrende des konischen Rohrs wird auf einen möglichst kurzen Abstand zum Innenloch der Induktionsheizspule gebracht, damit eine hohe Energiedichte auf das Rohrende und das sich bildende Volumen von geschmolzenem Silizium induktiv übertragen werden kann. Anschließend wird ein einkristalliner Impfkristall an das Volumen von geschmolzenem Silizium angesetzt und, entsprechend der FZ-Methode, zunächst ein Dünnhals ("neck"), dann ein, bis zu einem Enddurchmesser konusförmig erweiterter Abschnitt des Einkristalls und schließlich ein Abschnitt mit konstantem Soll-Durchmesser kristallisiert. Das dafür notwendige Material an geschmolzenem Silizium wird durch Schmelzen der das Rohrende verschließenden Schicht, durch teilweises Schmelzen des konischen Rohrs vom Rohrende aus, durch teilweises Schmelzen der Platte von oben und später durch Schmelzen von Granulat aus Silizium bereitgestellt. Im Verlauf des Kristallisierens des konusförmig erweiterten Abschnitts des Einkristalls bildet sich eine Schmelze auf dem konusförmig erweiterten Abschnitt, die sich durch das Innenloch der, unter der Platte angeordneten Induktionsheizspule erstreckt und die über eine Fest/Flüssig-Phasengrenze Kontakt zum Rohrende des konischen Rohrs hat. Wenn der Abschnitt mit dem konstanten Soll-Durchmesser kristallisiert wird oder gegebenenfalls auch schon zuvor, werden die Induktionsheizspule und die Schmelze so relativ zu einander positioniert, dass sich die Schmelze symmetrisch durch das Innenloch der Induktionsheizspule erstreckt.

Die Erfindung wird nachfolgend an Figuren näher erläutert.
Fig.1 zeigt eine Situation, die zu einem Zufrieren des Rohrendes führt.
Fig.2 zeigt, wie das Zufrieren des Rohrendes vermieden wird.

Wenn der konusförmig erweiterte Abschnitt des Einkristalls kristallisiert wird, besteht die Gefahr, dass sich das konische Rohr im Bereich des Rohrendes durch fest werdendes Silizium zunehmend verengt, bis das Rohrende vollständig verschlossen ist. Die Folge davon ist, dass das Wachstum des Einkristalls zum Erliegen kommt, weil geschmolzenes Silizium durch das konische Rohr nicht mehr zur Verfügung gestellt werden kann und/oder weil sich geschmolzenes Silizium im konischen Rohr staut und schließlich mit der ersten, über der sich drehenden Platte aus Silizium angeordneten Induktionsheizspule in Kontakt kommt.

Der Grund dafür wird von den Erfindern darin gesehen, dass der Außendurchmesser des Rohrendes des konischen Rohrs während einer kritischen Phase, in der der konusförmig erweiterte Abschnitt des Einkristalls einen Durchmesser von 15 bis 30 mm aufweist und kristallisiert wird, nicht hinreichend groß ist, um einen das Zufrieren vermeidenden Verlauf der Fest/Flüssig Phasengrenze zwischen dem Rohrende und der Schmelze zu ermöglichen. Erfindungsgemäß wird ein solcher Verlauf der Phasengrenze sichergestellt, indem mit Hilfe der unter der Platte angeordneten Induktionsheizspule das Rohr vom Rohrende aus soweit geschmolzen wird, dass der Außendurchmesser des Rohrendes während der kritischen Phase nicht kleiner als 15 mm ist.

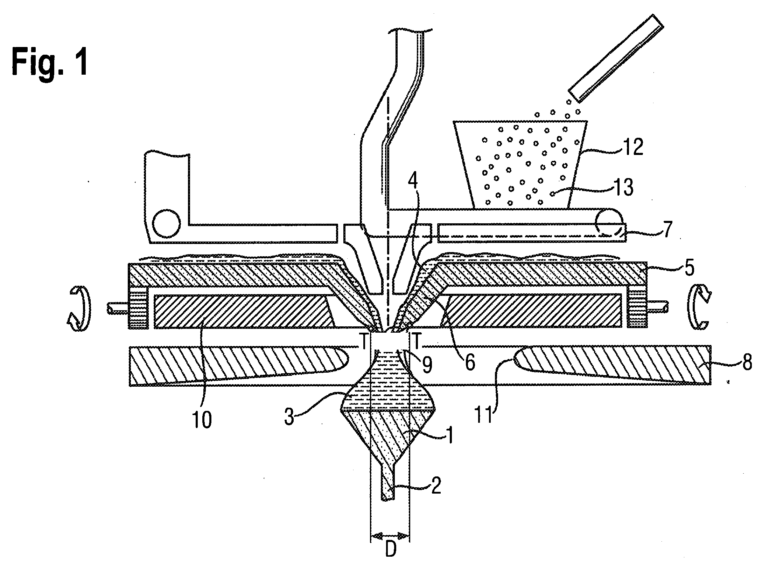

Fig. 1 zeigt den kristallisierenden, konusförmig erweiterten Abschnitt 1 des Einkristalls und einen Teil des zuvor kristallisierten Dünnhalses 2. Das weitere Kristallwachstum wird genährt durch die, auf dem konusförmig erweiterten Abschnitt liegende Schmelze 3 aus Silizium und durch den Film 4 aus geschmolzenem Silizium, der an der Innenwand des konischen Rohrs 6 der Platte 5 aus Silizium zur Schmelze 3 fließt. Der Film wird von der über der Platte angeordneten, ersten Induktionsheizspule 7 durch Anschmelzen der Plattenoberfläche erzeugt und flüssig gehalten. Zu einem späteren Zeitpunkt wird diese Induktionsheizspule 7 auch eingesetzt, um Granulat 13 aus Silizium, das durch einen Trichter 12 auf die Platte 5 gefördert wird, induktiv zu schmelzen. Der Film 4 wird dann hauptsächlich von geschmolzenem Granulat gebildet. Die Induktionsheizspule 7 hat vorzugsweise die Merkmale der in der DE 10 2008 013 326 A1 beschriebenen Induktionsheizspule. Die untere Seite der Platte 5 wird gekühlt, beispielsweise durch eine Kühlvorrichtung 10. Die zweite, unter der Platte 5 aus Silizium angeordnete Induktionsheizspule 8 wird hauptsächlich in gleicher Weise wie beim FZ-Verfahren betrieben, zunächst um den, bis zu einem Enddurchmesser konusförmig erweiterten Abschnitt 1 und danach um den Abschnitt des Einkristalls mit gleich bleibendem Soll-Durchmesser kontrolliert zu kristallisieren.

Während der kritischen Phase, wenn der Durchmesser des konusförmig erweiterten Abschnitts 1 des Einkristalls auf 15 bis 30 mm angewachsen ist und der Außendurchmesser D des Rohrendes des konusförmigen Rohrs 6 kleiner als 15 mm ist oder wird, besteht eine hohe Wahrscheinlichkeit, dass das konusförmige Rohr 6 am Rohrende zufriert. Je kleiner der Außendurchmesser D ist, desto steiler fällt die Fest/Flüssig-Phasengrenze 9 vom Tripelpunkt T am äußeren Rand des Rohrendes des konischen Rohrs 6 nach innen. Wegen des Gefälles tendiert der Tripelpunkt T dazu, sich entlang der Phasengrenze 9 nach innen zu verschieben. Infolgedessen wird der Abstand zwischen der Schmelze 3 und der zweiten Induktionsheizspule 8 größer, wodurch weniger Energie auf die Schmelze 3 übertragen wird und die Schmelze 3 am Rohrende des konischen Rohrs 6 festzufrieren droht. Das Verringern des Abstands zwischen Induktionsheizspule 8 und Schmelze 3 oder eine Erhöhung der Heizleistung der Induktionsheizspule 8 schafft in dieser Situation keine Abhilfe mehr. Derartige Maßnahmen fördern sogar die zunehmende Verengung des Rohrendes, weil der elektromagnetische Druck die Schmelze 3 und den Tripelpunkt T dann noch weiter nach innen drückt.

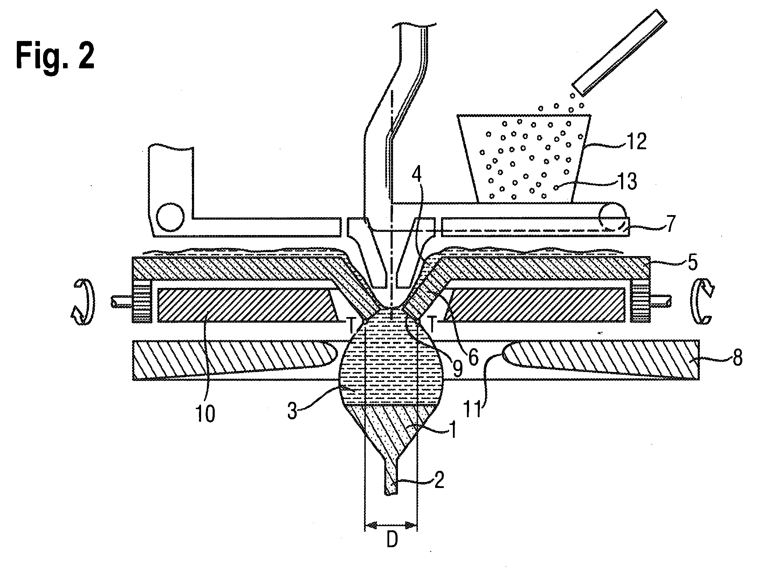

Um zuverlässig zu vermeiden, dass der beschriebene Mechanismus abläuft, wird mit Hilfe der unter der Platte 5 angeordneten Induktionsheizspule 8 das konusförmige Rohr 6 vom Rohrende aus soweit geschmolzen, dass der Außendurchmesser D des Rohrendes während der kritischen Phase nicht kleiner als 15 mm ist. Dadurch erreicht man einen Verlauf der Fest/Flüssig-Phasengrenze, wie er in Fig.2 dargestellt ist. Die Fest/Flüssig-Phasengrenze steigt vom Tripelpunkt T am äußeren Rand des Rohrendes des konusförmigen Rohrs 6 nach innen an. Die Steigung reicht aus, dass der Tripelpunkt T stabil am äußeren Rand des Rohrendes des konischen Rohrs 6 bleibt, und der Abstand zwischen der zweiten Induktionsheizspule 8 und der Schmelze 3 nicht größer wird.

Der Durchmesser des Innenlochs 11 der zweiten Induktionsheizspule 8 ist größer als der Durchmesser der Schmelze 3 und beträgt vorzugsweise mehr als 30 mm und nicht mehr als 40 mm. Das Verhältnis des Außendurchmessers des Rohrendes des konusförmigen Rohrs 6 und des Durchmessers des Innenlochs 11 ist während der kritischen Phase vorzugsweise 1:3 oder größer, besonders bevorzugt 1:3 bis 4:5.

Ist der konusförmig erweiterte Abschnitt 1 bereits auf einen Durchmesser von mehr als 30 mm angewachsen, reicht die Menge an zur Schmelze nachfließendem, geschmolzenem Silizium in der Regel aus, um zu verhindern, dass das Rohrende des konischen Rohrs 6 zufriert, auch wenn der Außendurchmesser D des Rohrendes des konischen Rohrs unter 15 mm fällt.

### Beispiel:

Es wurde eine Reihe von Einkristallen aus Silizium mit einem Durchmesser von 100 mm durch Umschmelzen von Granulat produziert. Die nachfolgende Tabelle zeigt die Anzahl der Ansetzversuche an, die durchschnittlich notwendig waren, um einen Einkristall erfolgreich herzustellen, und zwar in Abhängigkeit des Außendurchmessers des Rohrendes des konischen Rohrs im Zeitraum zwischen dem Erreichen eines Durchmessers des konusförmig erweiterten Abschnitts von 15 mm und dem Erreichen eines Durchmessers von 30 mm.

| Außendurchmesser des Rohrendes | Ansetzversuche |
|---|---|
| weniger als 15 mm | 4 |
| 15 mm und größer | 1 |

## Patentansprüche

1. Verfahren zur Herstellung eines Einkristalls aus Silizium durch Umschmelzen von Granulat, umfassend
das Kristallisieren eines konusförmig erweiterten Abschnitts (1) des Einkristalls mit Hilfe einer Induktionsheizspule (8), die unter einer sich drehenden Platte 5 aus Silizium angeordnet ist; und
das Zuführen von induktiv geschmolzenem Silizium durch ein konisches Rohr (6) der Platte (5), das eine zentrale Öffnung der Platte (5) umschließt und sich unter die Platte erstreckt, zu einer Schmelze (3), die sich auf dem konusförmig erweiterten Abschnitt (1) des Einkristalls befindet und die Kontakt zu einem Rohrende des konischen Rohrs (6) hat, **dadurch gekennzeichnet, dass** mit Hilfe der unter der Platte (5) angeordneten Induktionsheizspule (8) ausreichend Energie bereitgestellt wird, damit der Außendurchmesser D des Rohrendes nicht kleiner als 15 mm ist, solange der konusförmig erweiterte Abschnitt (1) des Einkristalls einen Durchmesser von 15 bis 30 mm aufweist und kristallisiert wird.

2. Verfahren nach Anspruch 1, **dadurch gekennzeichnet, dass** mit Hilfe der unter der Platte (5) angeordneten Induktionsheizspule (8) ausreichend Energie bereitgestellt wird, damit das Verhältnis des Außendurchmessers D des Rohrendes und des Durchmessers eines Innenlochs (11) der Induktionsheizspule 1:3 oder größer ist, solange der konusförmig erweiterte Abschnitt (1) des Einkristalls einen Durchmesser von 15 bis 30 mm aufweist und kristallisiert wird.

## Claims

1. Method for producing a single crystal composed of silicon by remelting granules, comprising crystallizing a conically extended section (1) of the single crystal with the aid of an induction heating coil (8) arranged below a rotating plate (5) composed of silicon; and
feeding inductively melted silicon through a conical tube (6) in the plate (5), said tube enclosing a central opening of the plate (5) and extending below the plate, to a melt (3) that is situated on the conically extended section (1) of the single crystal and has contact with a tube end of the conical tube (6), **characterized in that**, with the aid of the induction heating coil (8) arranged below the plate (5), enough energy is provided in order that the external diameter D of the tube end is not smaller than 15 mm as long as the conically extended section (1) of the single crystal has a diameter of 15 to 30 mm and is crystallized.

2. Method according to Claim 1, **characterized in that**, with the aid of the induction heating coil (8) arranged below the plate (5), enough energy is provided in order that the ratio of the external diameter D of the tube end and the diameter of an internal hole (11) in the induction heating coil is 1:3 or greater as long as the conically extended section (1) of the single crystal has a diameter of 15 to 30 mm and is crystallized.

## Revendications

1. Procédé de fabrication d'un monocristal de silicium par refusion d'un granulat, comprenant la cristallisation d'une section élargie en forme de cône (1) du monocristal à l'aide d'un serpentin de chauffage par induction (8) qui est agencé sous une plaque rotative (5) en silicium ; et
l'introduction de silicium fondu par induction par un tube conique (6) de la plaque (5), qui entoure une ouverture centrale de la plaque (5) et s'étend sous la plaque, dans une masse fondue (3) qui se trouve sur la section élargie en forme de cône (1) du monocristal et qui est en contact avec une extrémité tubulaire du tube conique (6), **caractérisé en ce qu'**à l'aide du serpentin de chauffage par induction (8) agencé sous la plaque (5), suffisamment d'énergie est mise à disposition pour que le diamètre extérieur D de l'extrémité tubulaire ne soit pas inférieur à 15 mm dans la mesure où la section élargie en forme de cône (1) du monocristal présente un diamètre de 15 à 30 mm et est cristallisée.

2. Procédé selon la revendication 1, **caractérisé en ce qu'**à l'aide du serpentin de chauffage par induction (8) agencé sous la plaque (5), suffisamment d'énergie est mise à disposition pour que le rapport entre le diamètre extérieur D de l'extrémité tubulaire et le diamètre d'un orifice intérieur (11) du serpentin de chauffage par induction soit supérieur ou égal à 1:3, dans la mesure où la section élargie en forme de cône (1) du monocristal présente un diamètre de 15 à 30 mm et est cristallisée.
